# DEMANDE DE BREVET EUROPEEN

(11) **EP 1 223 616 A2**
(43) Date de publication de la demande: **17.07.2002**
(21) Numéro de dépôt: 02290040.1
(22) Date de dépôt: 09.01.2002
(51) Int. Cl.: H01L 21/8242

(54) **Point mémoire de type DRAM avec tranchée capacitive, et procédé de fabrication**

(30) Priorité: 12.01.2001 FR 0100418
(71) Demandeur: STMicroelectronics S.A., 92120 Montrouge (FR)
(72) Inventeur: Enut, Olivier, 38000 Grenoble (FR); Gris, Yvon, 38000 Tullins (FR)
(74) Mandataire: Casalonga, Axel

(57) **Abrégé**

Le circuit intégré, comprend un substrat semiconducteur SB supportant un point mémoire PM de type DRAM comportant un transistor d'accès T et un condensateur de stockage TRC. Le transistor d'accès est réalisé sur le substrat, et le substrat comporte une tranchée capacitive TRC enterrée sous le transistor et formant ledit condensateur de stockage, ladite tranchée capacitive étant en contact avec l'une des régions de source et de drain du transistor

## Description

L'invention concerne les circuits intégrés, et plus particulièrement les points mémoire dynamiques à accès aléatoire de type DRAM (Dynamic Random Access Memory en langue anglaise).

Un point mémoire de type DRAM doit pour des raisons de densité être le plus petit possible. Il est constitué d'un transistor d'accès commandant la charge ou la décharge d'un condensateur. Ce condensateur doit d'une part présenter une valeur capacitive maximale et d'autre part occuper une surface minimale. Actuellement le condensateur est réalisé soit dans le substrat en silicium soit dans les couches supérieures d'interconnexion du circuit intégré.

Dans le premier cas le condensateur est situé à côté du transistor d'accès. Dans le deuxième cas, le condensateur occupe un volume important au-dessus du transistor, volume qui ne peut pas être utilisé pour réaliser des interconnexions du circuit intégré.

Dans ces deux cas, la densité du point mémoire, c'est-à-dire son encombrement, s'en trouve affectée.

Par ailleurs, les procédés de fabrication des composants semiconducteurs peuvent détruire la continuité cristalline de la surface d'une partie du substrat initial semiconducteur monocristallin. C'est notamment le cas lors de la réalisation d'une tranchée. Le substrat semiconducteur présente, à l'endroit de la tranchée, un matériau différent sans structure cristalline. En conséquence la surface de la partie du substrat occupée par la tranchée, est inutilisable pour réaliser des dispositifs semiconducteurs.

L'invention permet d'apporter une solution à ces problèmes.

Un but de l'invention est de permettre la réalisation d'un substrat monocristallin autorisant la formation ultérieure d'une couche épitaxiale de silicium exempte de défauts cristallins et dans laquelle on réalisera le transistor du point mémoire.

Un autre but de l'invention est de proposer un dispositif semiconducteur fonctionnant comme un point mémoire de type DRAM, et présentant un encombrement minimal.

L'invention propose donc un procédé de fabrication d'un circuit intégré comprenant un substrat semiconducteur supportant un point mémoire de type DRAM comportant un transistor d'accès et un condensateur de stockage. Selon une caractéristique générale de l'invention,
a) on élabore un substrat initial monocristallin présentant localement une tranchée capacitive contenant un matériau de remplissage polycristallin, débouchant à la surface du substrat initial et formant une discontinuité du réseau cristallin,
b) on évide le substrat initial au niveau de la tranchée,
c) on amorphise de façon localisée et autoalignée sur la tranchée, le réseau monocristallin du substrat en périphérie de l'évidemment et la partie émergente du matériau de remplissage polycristallin de la tranchée,
d) on dépose sur la structure obtenue à l'étape précédente une couche de matière amorphe ayant la même composition chimique que celle du substrat initial,
e) on effectue un recuit thermique de la structure obtenue à l'étape précédente afin de recristalliser la matière amorphe en continuité avec le réseau monocristallin du substrat initial,
f) on fait croître par épitaxie une couche supérieure de substrat dans et sur laquelle on réalise le transistor d'accès, ladite tranchée capacitive formant le condensateur de stockage étant en contact avec l'une des régions de source et de drain du transistor.

Selon un mode de mise en oeuvre, le procédé comprend, préalablement ou postérieurement à l'étape e), une étape d'aplanissement de surface, par exemple un polissage mécano-chimique.

Selon un mode de mise en oeuvre, l'étape d'amorphisation comporte une implantation ionique localisée autour de l'évidemment par une opération de masquage.

Selon un mode de mise en oeuvre, dans l'étape a), on dépose successivement sur le substrat initial une première couche d'un premier matériau et une deuxième couche d'un deuxième matériau, puis on grave une tranchée que l'on remplit avec un matériau de remplissage,
et dans l'étape b), on effectue une gravure sélective vis-à-vis de ladite deuxième couche, de la première couche et d'une partie supérieure du matériau de remplissage de la tranchée, de façon à former des cavités latérales et ledit évidemment au niveau de la discontinuité cristalline, et on retire ladite deuxième couche .

Dans l'étape a), le remplissage de la tranchée comprend avantageusement les étapes suivantes :
- on tapisse les parois de la tranchée avec de l'oxyde par oxydation thermique ;
- on dépose du silicium polycristallin fortement dopé dans la tranchée de manière à la remplir ;
- on grave le silicium polycristallin déposé précédemment de manière à ce que le niveau de remplissage de la tranchée soit en dessous de la surface du substrat initial.
L'invention a également pour objet un circuit intégré obtenu par le procédé de fabrication tel que défini ci-avant, et comprenant un substrat semiconducteur supportant un point mémoire de type DRAM comportant un transistor d'accès et un condensateur de stockage.

Ainsi le substrat comporte au moins une tranchée capacitive enterrée sous le transistor et formant ledit condensateur de stockage, ladite tranchée capacitive étant en contact avec l'une des régions de source et de drain du transistor.

En d'autre termes, le point mémoire ainsi obtenu selon l'invention est un transistor avec un condensateur de type tranchée enterrée située non pas à côté du transistor mais sous le transistor. L'encombrement est donc réduit. La première électrode du condensateur est le substrat et la deuxième électrode est un conducteur remplissant la tranchée. Ce condensateur est situé au-dessous d'une zone de diffusion (drain ou source) du transistor d'accès, et est relié à cette zone de diffusion par contact direct entre l'électrode interne du condensateur et cette zone de diffusion.

Le substrat est par exemple formé de silicium, et la tranchée capacitive comporte une zone interne de silicium dopé, partiellement enveloppée d'une paroi isolante séparant latéralement ladite zone interne du substrat, et surmontée d'une zone supérieure de silicium dopé, cette zone supérieure étant en contact avec ladite région de source ou de drain du transistor.

Selon un mode de réalisation, le substrat comporte une partie inférieure fortement dopée avec une conductivité de type P, de préférence avec une concentration de dopants supérieure à 10¹⁸ at/cm³ par exemple égale à 10¹⁹ at/cm³ et une partie supérieure de conductivité P, moins dopée que la partie inférieure. La zone interne et la zone supérieure de la tranchée capacitive ont une conductivité de type N, et les régions de source et de drain du transistor ont également une conductivité de type N.

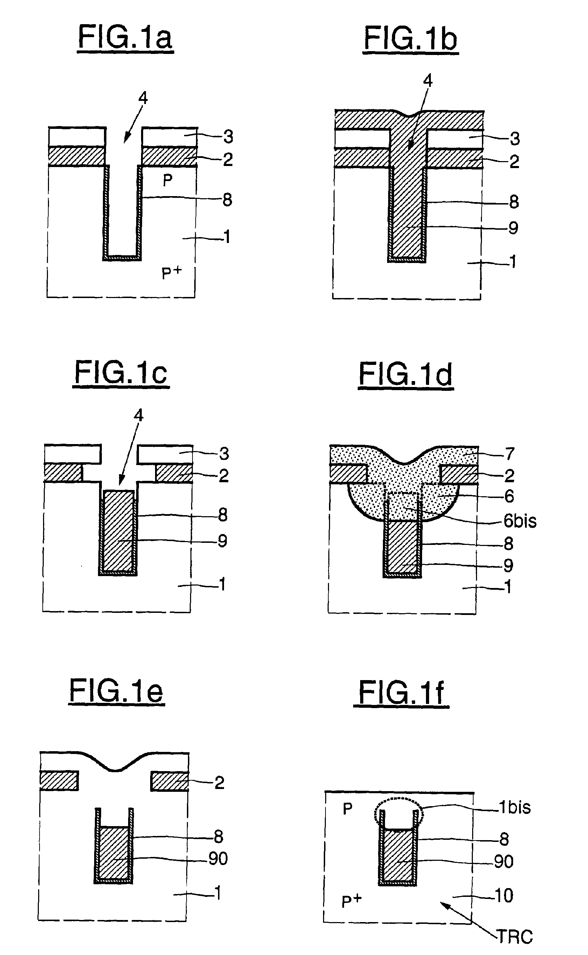

D'autres avantages et caractéristique de l'invention apparaîtront à l'examen de la description détaillée de modes de réalisation et de mise en oeuvre, nullement limitatifs, et des dessins annexés sur lesquels les figures 1a à 1h illustrent schématiquement les principales étapes d'un procédé selon l'invention ainsi qu'un mode de réalisation d'un point mémoire selon l'invention.

Le substrat de départ du procédé de l'invention, ou substrat initial, est illustré sur la figure 1a et comporte ici une tranchée. Le substrat initial 1 comporte une partie inférieure dopée P⁺ (concentration de dopants égale à 10¹⁹ at/cm³). Le substrat possède également une partie supérieure épitaxiée sur la partie inférieure et dopée P avec une concentration de 5.10¹⁴ at/cm³. La tranchée peut être réalisée, selon une mise en oeuvre du procédé de l'invention, par dépôt dans un premier temps d'une couche d'oxyde de silicium 2 sur le substrat initial en silicium monocristallin 1. L'épaisseur de cette couche 2 peut varier entre 0,01 micron et 1 micron, et est de préférence de l'ordre de 2000 Å.

On dépose ensuite sur l'oxyde 2 une couche de nitrure de silicium 3. L'épaisseur de cette couche 3 peut également varier entre 0,01 micron et 1 micron, et est également de préférence de l'ordre de 2000 Å.

On grave ensuite, de manière classique, tout d'abord le nitrure 3 et l'oxyde 2, puis finalement le silicium monocristallin du substrat 1 à l'aide d'une opération de photo-lithographie, pour former la tranchée 4.

La tranchée 4 a une profondeur d'au moins 5µm et une largeur variable, de préférence inférieure à 1µm.

On effectue ensuite une oxydation thermique contrôlée de manière à former sur les parois de la tranchée 4 une couche d'oxyde de silicium 8 d'épaisseur comprise entre 40 et 1000 Å, de préférence entre 50 et 300 Å. on obtient le dispositif illustré à la figure la.

On dépose ensuite sur la plaquette et de manière à remplir la tranchée 4, du silicium polycristallin 9 fortement dopé N⁺. Le dopage du silicium est réalisé in situ.

On obtient un dispositif tel qu'illustré à la figure 1b.

On grave ensuite le silicium polycristallin 9, déposé précédemment, au moins de manière à le retirer de la surface de la plaquette. Par ailleurs, cette gravure est menée jusqu'à ce que le niveau du silicium polycristallin dans la tranchée 4 soit en dessous de la surface du substrat initial 1.

L'étape suivante consiste en une désoxydation contrôlée, essentiellement de manière à former sous la couche de nitrure de silicium 3 deux cavités latérales de largeur donnée dans la couche d'oxyde 2 comme l'illustre la figure 1c. On retire également une partie de l'oxyde de silicium 8 dans la tranchée 4.

Cette désoxydation s'effectue par gravure isotrope à l'acide fluorhydrique ou encore par gravure plasma isotrope au fluor. On obtient alors le dispositif illustré à la figure 1c sur laquelle la tranchée est tapissée d'une couche d'oxyde de silicium 8 dont la hauteur est inférieure à la hauteur de la couche de silicium polycristallin dopé 9 dans la tranchée 4. Deux cavités latérales de largeur donnée apparaissent sous la couche de nitrure de silicium 3 et dans la couche d'oxyde de silicium 2.

On retire ensuite de manière classique le masque de nitrure de silicium 3.

On amorphise ensuite le silicium découvert.

Le silicium découvert à ce stade du procédé est le silicium monocristallin du substrat 1, ainsi que la partie émergente de silicium polycristallin dopé 9 dans la tranchée 4. On crée ainsi des zones de silicium amorphe référencées 6 et 6bis (figure 1d).

L'amorphisation simultanée localisée des régions 6 et 6bis est auto-alignée sur la tranchée. L'amorphisation s'effectue de manière classique par destruction du réseau cristallin du silicium et du silicium polycristallin 6bis, par exemple par implantation de particules lourdes tels que les ions. Dans le cadre de l'invention, on préférera notamment l'implantation d'ions fluorure.

On dépose ensuite sur toute la surface de la plaquette une couche de silicium amorphe 7 de manière à au moins combler les cavités latérales et l'évidemment au dessus de la tranchée 4. La couche amorphe 7 déposée a donc ici un rôle de liaison entre les régions 6 et 6bis ainsi que de rebouchage de la surface, et non un rôle de zone active. Le dépôt de silicium amorphe se fait de manière classique à basse température. On peut par exemple utiliser un four LPCVD (dépôt chimique basse pression)en injectant du silane à température suffisamment faible, par exemple inférieure à 600°C, typiquement à 400°C. On obtient alors le dispositif illustré à la figure 1d, sur laquelle dans une tranchée 4 gravée dans un substrat 1, un bloc de silicium polycristallin 9 est partiellement enveloppé dans une couche d'oxyde de silicium 8. La hauteur de ce bloc, inférieure à celle de la tranchée 4, est également inférieure à la hauteur de l'enveloppe d'oxyde de silicium 8. Cet élément est surmonté d'une zone de silicium amorphe comportant les zones de silicium amorphisé 6 et 6bis et le silicium amorphe 7 déposé.

On effectue un recuit thermique de manière à restaurer la structure cristalline du silicium amorphe. Le recuit thermique permet de recristalliser le silicium amorphe en créant une ré-épitaxie du silicium amorphe 6, 7 à partir du silicium monocristallin du substrat initial 1. La restructuration du réseau de silicium monocristallin conduit à la figure le où la précédente couche de silicium amorphe se fond maintenant avec le silicium monocristallin du substrat 1.

Il convient de noter ici que selon l'invention, la zone 6 est spatialement limitée, et la frontière entre cette zone 6 et la substrat 1 est facilement localisée par l'implantation ionique. Cette frontière est par ailleurs une frontière « douce », c'est à dire que le passage de l'état Si monocristallin à l'état Si amorphe est très progressif. Ces caractéristiques conduisent à un bon rendement de recristallisation de la zone 6, et à une recristallisation sans défauts, que l'on peut difficilement obtenir avec une surface à recristalliser importante.

De plus l'amorphisation de la zone 6bis permet d'éviter une « remontée » de défauts cristallins dans la couche monocristalline à partir du silicium polycristallin.

On effectue ensuite un polissage mécano chimique s'arrêtant sur la couche d'oxyde de silicium 2 pour retirer la couche de silicium recristallisé en surface de la plaquette. On élimine ensuite de manière classique la couche d'oxyde de silicium 2. Puis, afin de planifier la surface, on soumet la plaquette à un ultime polissage mécano chimique.

Après les étapes d'égalisation de la surface du substrat, on obtient un substrat final 10 en silicium monocristallin illustré à la figure 1f, dont la surface monocristalline parfaitement plane et uniforme permet la croissance épitaxiale sans défaut de silicium monocristallin. L'épaisseur du substrat 10 au dessus de la tranchée est de l'ordre de 0,2 micron. Le substrat comporte par ailleurs une tranchée capacitive enterrée TRC, ayant par conséquent une profondeur minimale de 5 microns environ, et constituée de silicium polycristallin 90 fortement dopé partiellement enveloppé d'une paroi d'oxyde de silicium 8 le séparant latéralement du substrat 1. Au-dessus de cette tranchée capacitive enterrée et dans le substrat 1, il subsiste une zone dopée 1bis, de même conductivité que le silicium polycristallin 90. Cette zone correspond à la zone de silicium polycristallin amorphisée 6bis ainsi qu'à la partie de silicium 7 dopée par diffusion des dopants lors du recuit.

La destruction localisée selon l'invention du réseau cristallin avant sa restructuration, est particulièrement avantageuse pour des tranchées capacitives, car elle permet d'enterrer le silicium polycristallin 90 (toute la capacité) par une gravure contrôlée de l'oxyde de flanc 8, sans qu'il soit nécessaire de prévoir un oxyde supplémentaire.

Le procédé se poursuit par une croissance épitaxiale sur la surface du substrat 10, d'une couche supérieure de substrat 12, formée de silicium dopé P (figure 1g). C'est dans cette couche 12 que va être réalisé le transistor d'accès du point mémoire PM.

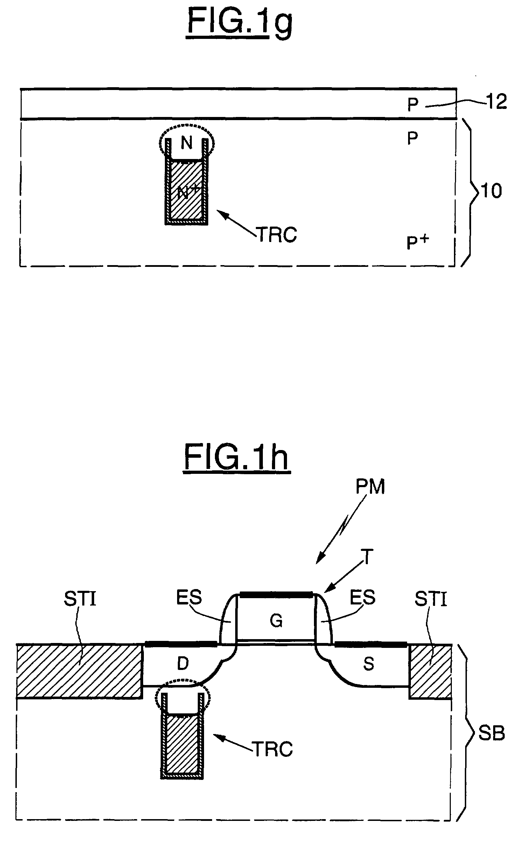

Plus précisément, comme illustré sur la figure 1h, le substrat SB, formé du substrat 10 et de la couche 12, incorpore la tranchée capacitive TRC et les zones de drain D et de source S du transistor T. La zone supérieure 1bis de la tranchée vient en contact électrique de la région diffusée de drain D.

Les étapes permettant la réalisation du transistor T sont classiques et connues en elles-mêmes de l'homme du métier. Plus précisément, on réalise les zones d'isolation latérales STI. Puis on forme l'oxyde de grille, puis le polysilicium de grille que l'on grave de façon à former la grille isolée T du transistor.

Les régions de drain et de source sont réalisées de façon classique par double implantation avant et après formation des espaceurs isolants ES flanquant la grille. Une étape classique de siliciuration permet de métalliser les régions de drain, source et grille de façon à permettre des prises de contacts.

## Revendications

1. Procédé de fabrication d'un circuit intégré comprenant un substrat semiconducteur supportant un point mémoire de type DRAM comportant un transistor d'accès et un condensateur de stockage, **caractérisé par le fait que** :
a) on élabore un substrat initial monocristallin (1) présentant localement une tranchée capacitive contenant un matériau de remplissage polycristallin, débouchant à la surface du substrat initial et formant une discontinuité du réseau cristallin,
b) on évide le substrat initial au niveau de la tranchée,
c) on amorphise de façon localisée et autoalignée sur la tranchée, le réseau monocristallin du substrat en périphérie de l'évidemment et la partie émergente du matériau de remplissage polycristallin de la tranchée,
d) on dépose sur la structure obtenue à l'étape précédente une couche de matière amorphe ayant la même composition chimique que celle du substrat initial,
e) on effectue un recuit thermique de la structure obtenue à l'étape précédente afin de recristalliser la matière amorphe en continuité avec le réseau monocristallin du substrat initial,
f) on fait croître par épitaxie une couche supérieure de substrat dans et sur laquelle on réalise le transistor d'accès, ladite tranchée capacitive formant le condensateur de stockage étant en contact avec l'une des régions de source et de drain du transistor..

2. Procédé selon la revendication 1, **caractérisé par le fait qu'**il comprend, préalablement ou postérieurement à l'étape e), une étape d'aplanissement de surface.

3. Procédé selon la revendication 2, **caractérisé par le fait que** l'étape d'aplanissement comporte un polissage mécano-chimique.

4. Procédé selon l'une des revendications 1 à 3, **caractérisé par le fait que** l'étape d'amorphisation comporte une implantation ionique localisée autour de l'évidemment par une opération de masquage.

5. Procédé selon l'une des revendications 1 à 4, **caractérisé par le fait que** dans l'étape a), on dépose successivement sur le substrat initial (1) une première couche (2) d'un premier matériau et une deuxième couche (3) d'un deuxième matériau, puis on grave une tranchée (4) que l'on remplit avec un matériau de remplissage,
et **par le fait que** dans l'étape b), on effectue une gravure sélective vis-à-vis de ladite deuxième couche (3), de la première couche et d'une partie supérieure du matériau de remplissage de la tranchée, de façon à former des cavités latérales et ledit évidemment au niveau de la discontinuité cristalline, et on retire ladite deuxième couche (2).

6. Procédé selon la revendication 5, **caractérisé en ce que** dans l'étape a), le remplissage de la tranchée comprend les étapes suivantes :
- on tapisse les parois de la tranchée (4) avec de l'oxyde (8) par oxydation thermique ;
- on dépose du silicium polycristallin (9) fortement dopé dans la tranchée (4) de manière à la remplir ;
- on grave le silicium polycristallin (9) déposé précédemment de manière à ce que le niveau de remplissage de la tranchée (4) soit en dessous de la surface du substrat initial (1).

7. Circuit intégré obtenu par le procédé de fabrication selon l'une des revendications 1 à 6, et comprenant un substrat semiconducteur supportant un point mémoire de type DRAM comportant un transistor d'accès et un condensateur de stockage.

8. Circuit intégré selon la revendication 7, **caractérisé par le fait que** le substrat comporte au moins une tranchée capacitive enterrée sous le transistor et formant ledit condensateur de stockage, ladite tranchée capacitive étant en contact avec l'une des régions de source et de drain du transistor.

9. Circuit intégré selon la revendication 8, **caractérisé par le fait que** le substrat est formé de silicium, et la tranchée capacitive comporte une zone interne de silicium dopé, partiellement enveloppée d'une paroi isolante séparant latéralement ladite zone interne du substrat, et surmontée d'une zone supérieure de silicium dopé, cette zone supérieure étant en contact avec ladite région de source ou de drain du transistor.

10. Circuit intégré selon la revendication 9, **caractérisé par le fait que** le substrat comporte une partie inférieure fortement dopée avec une conductivité de type P, de préférence avec une concentration de dopants supérieure à 10¹⁸ at/cm³ par exemple égale à 10¹⁹ at/cm³ et une partie supérieure de conductivité P, moins dopée que la partie inférieure, et **par le fait que** la zone interne et la zone supérieure de la tranchée capacitive ont une conductivité de type N, et les régions de source et de drain du transistor ont également une conductivité de type N.
